# EUROPEAN PATENT APPLICATION

(11) **EP 4 822 367 A1**
(43) Date of publication of application: **14.10.2026**
(21) Application number: 25841572.8
(22) Date of filing: 17.07.2025
(51) Int. Cl.: G01R 31/382, G01R 31/36, G01R 31/396, G01R 31/367, G01R 19/165

(54) **ELECTRONIC DEVICE AND BATTERY SOC ESTIMATION METHOD THEREFOR**

(30) Priority: 18.07.2024 KR 20240094928
(71) Applicant: LG Energy Solution, Ltd., Seoul 07335 (KR)
(72) Inventor: WON, Seongyeon, Daejeon 34122 (KR); CHOI, Chulho, Daejeon 34122 (KR); LIM, Jungho, Daejeon 34122 (KR)
(74) Representative: Plasseraud IP
(86) International application number: PCT/KR2025/010562
(87) International publication number: WO 2026/019281

(57) **Abstract**

An electronic device according to one embodiment of the present disclosure comprises: a memory that stores a plurality of estimation algorithms for estimating the state of charge (SOC) of a battery cell; and a processor operatively connected to the memory, wherein the processor can acquire open circuit voltage (OCV) data of the battery cell, identify, on the basis of the acquired OCV data, any one estimation algorithm from among the plurality of estimation algorithms stored in the memory, and estimate the SOC of the battery cell on the basis of the identified estimation algorithm.

## Description

### Technical Field

This application is based on and claims priority from Korean Patent Application No. 10-2024-0094928, filed on July 18, 2024, the disclosure of which is incorporated herein in its entirety by reference.

Embodiments described herein below relate to an electronic apparatus and a battery SOC estimation method therefor.

### Background Art

Research and development on secondary batteries are being conducted actively in recent years. The secondary batteries refer to batteries that can be charged and discharged repeatedly, including not only existing Ni/Cd batteries, Ni/MH batteries and so on, but also the latest lithium-ion batteries. Of the secondary batteries, the lithium-ion batteries have the advantage of a significantly higher energy density than the existing Ni/Cd batteries, Ni/MH batteries, and so on. Further, the lithium-ion batteries can be manufactured in a compact and lightweight form, making them suitable to be used as power sources of mobile devices, and recently, as their applications have expanded to power sources of electric vehicles, the lithium-ion batteries are gaining attention as an energy storage medium of next generation.

The lithium secondary batteries are typically manufactured by interposing a separator between a positive electrode, which includes a positive electrode active material including a lithium-containing transition metal oxide, and a negative electrode, which includes a negative electrode active material capable of storing lithium ions, to form an electrode assembly, inserting the electrode assembly into a battery case, injecting a non-aqueous electrolyte serving as a medium for transferring lithium ions, and sealing the battery case. In general, the non-aqueous electrolyte includes a lithium salt, and an organic solvent capable of dissolving the lithium salt.

Meanwhile, with the expanding applications of the secondary batteries, the importance of technologies related to management systems for more efficiently using and managing the secondary batteries are increasing. For example, the management systems are required to accurately estimate the state of charge (SOC) of the secondary batteries, in order to appropriately adjust a charging or discharging output and a capacity utilization strategy for the secondary batteries.

Typically, in order to estimate the State of Charge (SOC) of a secondary battery, a method is used that estimates the SOC from the Open Circuit Voltage (OCV) of the secondary battery by using an SOC-OCV relationship representing a relationship between the SOC and the OCV of the secondary battery. The SOC-OCV relationship is an inherent characteristic determined according to electrode components of a secondary battery, and since, in some secondary batteries, the SOC-OCV relationship does not significantly change even as the batteries degrade, SOC estimation algorithms based on the SOC-OCV relationship at the Beginning of Life (BOL) of the secondary battery are used.

Meanwhile, development has recently progressed on battery cells including lithium-excess manganese-rich (Mn-rich) oxide as a positive electrode active material (hereinafter, referred to as manganese-rich cells), to reduce the manufacturing costs of batteries for electric vehicles. The lithium-excess manganese-rich oxide has the advantages of low cost and superior stability compared to conventional lithium nickel-based positive electrode active materials. However, since the SOC-OCV relationship of the manganese-rich cells changes with the degradation thereof, it is difficult to use the conventional SOC estimation algorithms.

It is necessary to determine the cause of the change in SOC-OCV relationship of a manganese-rich cell with the degradation thereof, and apply an SOC estimation algorithm taking into account the characteristic of the manganese-rich cell.

### Detailed Description of the Invention

### Technical Goals

According to an embodiment of the present disclosure, it is possible to provide an electronic apparatus, which may identify an estimation algorithm suitable for a current OCV value of a battery cell from a plurality of estimation algorithms based on OCV data of the battery cell, and estimate the SOC of the battery cell based on the identified estimation algorithm, and a battery SOC estimation method therefor.

Advantages of the embodiments of the present disclosure are not limited to those described above, and other advantages may be inferred from embodiments described herein below.

### Technical solutions

An electronic apparatus according to an embodiment of the present disclosure includes: a memory storing a plurality of estimation algorithms for estimating a state of charge (SOC) of a battery cell; and a processor operatively coupled to the memory, wherein the processor acquires open circuit voltage (OCV) data of the battery cell, based on the acquired OCV data of the battery cell, identifies any one estimation algorithm from the plurality of estimation algorithms stored in the memory, and based on the identified estimation algorithm, estimates the SOC of the battery cell.

In the electronic apparatus according to an embodiment of the present disclosure, the plurality of estimation algorithms may include a first estimation algorithm and a second estimation algorithm, based on the acquired OCV data, the processor may identify an OCV range including an OCV value of the battery cell, when the OCV value of the battery cell is included in a first OCV range, the processor may identify the first estimation algorithm from the plurality of estimation algorithms, and when the OCV value of the battery cell is included in a second OCV range, the processor may identify the second estimation algorithm from the plurality of estimation algorithms.

In the electronic apparatus according to an embodiment of the present disclosure, the processor may directly acquire the OCV data measured by a sensor, or acquire the OCV data from an external apparatus through a communication.

In the electronic apparatus according to an embodiment of the present disclosure, when the first estimation algorithm is identified from the plurality of estimation algorithms, the processor may estimate the SOC of the battery cell based on first SOC-OCV relationship information corresponding to the first OCV range, and when the second estimation algorithm is identified from the plurality of estimation algorithms, the processor may estimate the SOC of the battery cell based on second SOC-OCV relationship information corresponding to the second OCV range.

In the electronic apparatus according to an embodiment of the present disclosure, when the first estimation algorithm is identified from the plurality of estimation algorithms, the processor may estimate a first SOC corresponding to the first OCV range based on the first SOC-OCV relationship information, and based on the first SOC, estimate the SOC of the battery cell corresponding to an entire OCV range including the first OCV range and the second OCV range, and when the second estimation algorithm is identified from the plurality of estimation algorithms, the processor may estimate a second SOC corresponding to the second OCV range based on the second SOC-OCV relationship information, and based on the second SOC, estimate the SOC of the battery cell corresponding to an entire OCV range including the first OCV range and the second OCV range.

In the electronic apparatus according to an embodiment of the present disclosure, the first OCV range is a range equal to or greater than a specified OCV value, and the second OCV range is a range less than the specified OCV value.

In the electronic apparatus according to an embodiment of the present disclosure, the specified OCV value is about 3.2 V.

In the electronic apparatus according to an embodiment of the present disclosure, when the first estimation algorithm is identified from the plurality of estimation algorithms, the processor may estimate the first SOC by performing an Extended Kalman Filter operation based on the first SOC-OCV relationship information and the OCV value of the battery cell, multiply the first SOC by a first reference capacity corresponding to the first OCV range to obtain a charge capacity based on the specified OCV value, and divide a sum of a second reference capacity corresponding to the second OCV range and the charge capacity by a sum of the first reference capacity and the second reference capacity to estimate the SOC of the battery cell.

In the electronic apparatus according to an embodiment of the present disclosure, the battery cell may include a lithium-excess manganese-rich oxide as a positive electrode active material, and the first SOC-OCV relationship information may represent a relationship between an SOC and an OCV in the first OCV range of a lithium nickel cobalt manganese oxide that is part of the lithium-excess manganese-rich oxide.

In the electronic apparatus according to an embodiment of the present disclosure, when the second estimation algorithm is identified from the plurality of estimation algorithms, the processor may estimate the second SOC by performing an Extended Kalman Filter operation based on the second SOC-OCV relationship information and the OCV value of the battery cell, based on the second SOC, calculate a first depth of discharge (DoD) corresponding to the second OCV range, multiply the first DoD by a second reference capacity corresponding to the second OCV range to obtain a discharge capacity based on the specified OCV value, divide a sum of the first reference capacity corresponding to the first OCV range and the discharge capacity by a sum of the first reference capacity and the second reference capacity to obtain a second DoD of the battery cell corresponding to the entire OCV range of the battery cell, and based on the second DoD, estimate the SOC of the battery cell.

In the electronic apparatus according to an embodiment of the present disclosure, the battery cell may include a lithium-excess manganese-rich oxide as a positive electrode active material, and the second SOC-OCV relationship information may represent a relationship between an SOC and an OCV in the second OCV range of a lithium manganese oxide that is part of the lithium-excess manganese-rich oxide.

A battery cell SOC estimation method performed in an electronic apparatus includes: acquiring OCV data of the battery cell; based on the acquired OCV data, identifying any one estimation algorithm from a plurality of estimation algorithms; and based on the identified estimation algorithm, estimating the SOC of the battery cell.

In the battery cell SOC estimation method performed in an electronic apparatus according to an embodiment of the present disclosure, the acquiring the OCV data may include directly acquiring the OCV data measured by a sensor, or acquiring the OCV data from an external apparatus through a communication.

In the battery cell SOC estimation method performed in an electronic apparatus according to an embodiment of the present disclosure, the plurality of estimation algorithms may include a first estimation algorithm and a second estimation algorithm, and the identifying any one estimation algorithm from the plurality of estimation algorithms may include, based on the acquired OCV data, identifying an OCV range including an OCV value of the battery cell, when the OCV value of the battery cell is included in the first OCV range, identifying the first estimation algorithm from the plurality of estimation algorithms, and when the OCV value of the battery cell is included in the second OCV range, identifying the second estimation algorithm from the plurality of estimation algorithms.

In the battery cell SOC estimation method performed in an electronic apparatus according to an embodiment of the present disclosure, the estimating the SOC of the battery cell may include, when the first estimation algorithm is identified from the plurality of estimation algorithms, estimating a first SOC corresponding to the first OCV range based on the first SOC-OCV relationship information, and based on the first SOC, estimating the SOC of the battery cell corresponding to an entire OCV range including the first OCV range and the second OCV range, and when the second estimation algorithm is identified from the plurality of estimation algorithms, estimating a second SOC corresponding to the second OCV range based on the second SOC-OCV relationship information, and based on the second SOC, estimating the SOC of the battery cell corresponding to an entire OCV range including the first OCV range and the second OCV range.

In the method of estimating an SOC of a battery cell according to an embodiment of the present disclosure, the first OCV range may be a range equal to or greater than a specified OCV value, and the second OCV range may be a range less than the specified OCV value.

In the battery cell SOC estimation method performed in an electronic apparatus according to an embodiment of the present disclosure, the specified OCV value may be about 3.2 V.

In the battery cell SOC estimation method performed in an electronic apparatus according to an embodiment of the present disclosure, the estimating the SOC of the battery cell may include, when the first estimation algorithm is identified from the plurality of estimation algorithms, estimating the first SOC by performing an Extended Kalman Filter operation based on the first SOC-OCV relationship information and the OCV value of the battery cell, multiplying the first SOC by a first reference capacity corresponding to the first OCV range to obtain a charge capacity based on the specified OCV value, and dividing a sum of a second reference capacity corresponding to the second OCV range and the charge capacity by a sum of the first reference capacity and the second reference capacity to estimate the SOC of the battery cell.

In the battery cell SOC estimation method performed in an electronic apparatus according to an embodiment of the present disclosure, the estimating the SOC of the battery cell may include, when the second estimation algorithm is identified from the plurality of estimation algorithms, estimating the second SOC by performing an Extended Kalman Filter operation based on the second SOC-OCV relationship information and the OCV value of the battery cell, based on the second SOC, calculating a first depth of discharge (DoD) corresponding to the second OCV range, multiplying the first DoD by a second reference capacity corresponding to the second OCV range to obtain a discharge capacity based on the specified OCV value, dividing a sum of the first reference capacity corresponding to the first OCV range and the discharge capacity by a sum of the first reference capacity and the second reference capacity to obtain a second DoD of the battery cell corresponding to the entire OCV range of the battery cell, and based on the second DoD, estimating the SOC of the battery cell.

### Effects of the Invention

According to the embodiments described herein, an SOC estimation algorithm taking into account the characteristics of a manganese-rich cell is applied, so that the accuracy of SOC estimation may be improved.

The advantageous effects of the present disclosure are not limited to those described above, and other advantageous effects that are not described herein may clearly be understood to one of ordinary skill in the art from the descriptions in the claims.

### Brief Description of Drawings

FIG. 1 illustrates a graph representing OCV with respect to SOC at each of BOL (Beginning of Life) and MOL (Middle of Life) of a manganese-rich cell.
FIG. 2 illustrates a graph representing SOHC with respect to each OCV range of the manganese-rich cell, and a capacity with respect to each OCV range at each of BOL and MOL of the manganese-rich cell.
FIG. 3A illustrates a graph representing OCV with respect to SOC in a first OCV range of the manganese-rich cell.
FIG. 3B illustrates a graph representing OCV with respect to SOC in a second OCV range of the manganese-rich cell.
FIG. 4 is a block diagram of an electronic apparatus according to an embodiment of the present disclosure.
FIG. 5 is a view illustrating an example where the electronic apparatus according to an embodiment of the present disclosure estimates SOC of a battery cell based on a first estimation algorithm.
FIG. 6 is a view illustrating an example where the electronic apparatus according to an embodiment of the present disclosure estimates SOC of a battery cell based on a second estimation algorithm.
FIG. 7 is a flowchart of an operation of the electronic apparatus according to an embodiment of the present disclosure.
FIG. 8 is a flowchart of the operation of the electronic apparatus according to an embodiment of the present disclosure.

### Mode for Carrying Out the Invention

In describing embodiments of the present disclosure, descriptions of technologies that are well-known in the technical field of the present disclosure and are not directly related to the present disclosure will be omitted. This is intended to eliminate unnecessary descriptions, thereby clearly describing the present disclosure without obscuring the gist thereof.

For the same reason, some components are exaggerated, omitted, or schematically illustrated in the accompanying drawings. Thus, the size of each component may not accurately reflect the actual size thereof. In each drawing, the same or corresponding components are denoted by the same reference numerals.

Advantages and features of the present disclosure and methods for implementing them may be apparent from embodiments to be described in detail herein below with reference to the accompanying drawings. However, the present disclosure is not limited to the embodiments, but may be implemented in various forms. The embodiments are merely provided to thoroughly describe the present disclosure and comprehensively inform the scope of the present disclosure to one of ordinary skill in the art to which the present disclosure belongs, and the present disclosure can be defined by the scope described in the claims. Throughout the descriptions herein, the same reference numeral refers to the same components.

It may be appreciated that each block of flowcharts in the drawings and combinations of the flowcharts may be executed by computer program instructions. Since the computer program instructions may be loaded onto a processor of a general-purpose computer, a special-purpose computer, or other programmable data processing equipment, the instructions executed via the computer or other programmable data processing equipment produce means to perform the functions described in the flowchart block(s). Since the computer program instructions may also be stored in a computer-accessible or computer-readable memory that can be directed to the computer or other programmable data processing equipment in order to implement the functions in a specific manner, the instructions stored in the computer-accessible or computer-readable memory may make up a manufactured article including the instruction means to perform the functions described in the flowchart block(s). Since the computer program instructions may also be loaded onto the computer or other programmable data processing equipment, a series of operation steps may be performed on the computer or other programmable data processing equipment to create a process executed by the computer, such that the instructions executed on the computer or other programmable data processing equipment may provide steps for performing the functions described in the flowchart block(s).

Further, each block may represent a module, segment, or portion of a code that includes one or more executable instructions for performing specified logical function(s). It should be noted that in some alternative execution examples, the functions described in the blocks may be performed out of an order. For example, two blocks illustrated consecutively may actually be performed at the same time, and sometimes be performed in a reverse order according to corresponding functions.

In embodiments of the present disclosure, the terms "~units" indicate software components, or hardware components such as field-programmable gate array (FPGA) and application-specific integrated circuit (ASIC), and perform specific roles. However, the "~units" are not limited to software or hardware. The "~units" may be configured to be provided on an addressable storage medium or may be configured to activate one or more processors. Accordingly, as an example, the "~units" include components such as software components, object-oriented software components, class components, and task components, processes, functions, properties, procedures, subroutines, segments of a program code, drivers, firmware, microcode, circuits, data, databases, data structures, tables, arrays, and variables. The functions provided in the components and the "~units" may be combined into fewer components and "~units," or further divided into additional components and "~units." Also, the components and the "~units" may be implemented to activate one or more CPUs in a device or a secure multimedia card.

Throughout the descriptions, the expression "at least one of a, b, and c" may encompass "a alone," "b alone," "c alone," "a and b," "a and c," "b and c," or "all of a, b, and c."

As used herein below, a "terminal" may be implemented by a computer or a portable terminal that can connect to a server or other terminals through a network. Here, the computer includes, for example, a notebook, a desktop, and a laptop equipped with a Web Browser, and the portable terminal is, for example, a wireless communication device ensuring the portability and the mobility and may include any kind of handheld-based wireless communication devices such as communication-based terminals including International Mobile Telecommunication (IMT), Code Division Multiple Access (CDMA), W-Code Division Multiple Access (W-CDMA), and Long Term Evolution (LTE), smartphones, and tablet PCs.

Hereinafter, embodiments of the present disclosure will be described in detail with reference to the accompanying drawings to facilitate the practicing of the invention by one of ordinary skill in the art to which the present disclosure belongs. However, the present disclosure may be implemented in various different forms, and is not limited to the embodiments described herein below.

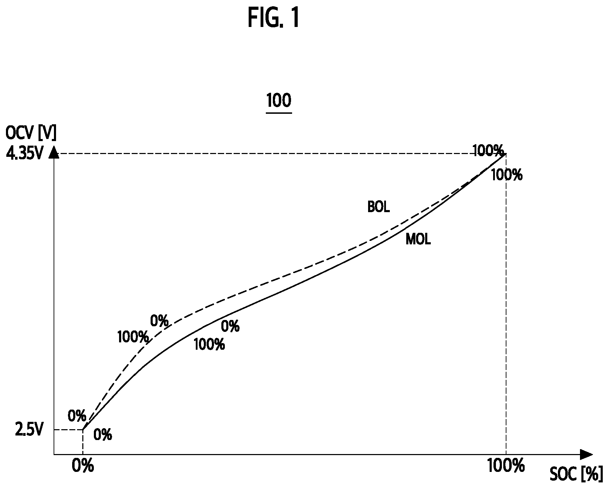

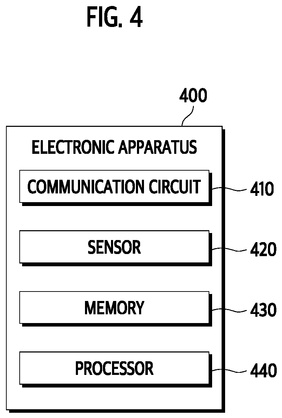

Hereinafter, the characteristic of the manganese-rich cell will be described with reference to FIGS. 1, 2, 3A, and 3B, and embodiments of the present disclosure will be described in detail with reference to FIGS. 4 to 8.

FIG. 1 illustrates a graph 100 representing the OCV with respect to the SOC at each of Begin of Life (BOL) and Middle of Life (MOL) of the manganese-rich cell. Here, according to an embodiment, the manganese-rich cell may be a battery cell including the lithium-excess manganese-rich (Mn-rich) oxide as the positive electrode active material. For example, the lithium-excess manganese-rich oxide may include a lithium manganese oxide (e.g., Li₂MnO₃) and a lithium nickel cobalt manganese oxide (e.g., NCM).

Referring to the graph 100 in FIG. 1, it may be seen that the SOC-OCV relationship of the manganese-rich cell differs at the BOL and the MOL. The difference may occur due to the phenomenon that the OCV of the manganese-rich cell decreases (OCV decay) as the secondary battery is repeatedly charged and discharged. The lithium-excess manganese-rich oxide included in the manganese-rich cell undergoes a phase transition during charging and discharging, and consequently, producing a manganese oxide (e.g., MnO₂). The produced manganese oxide participates in redox reactions, thereby increasing the capacity of the manganese-rich cell. This may be one of the causes of the OCV decrease phenomenon occurring in the manganese-rich cell.

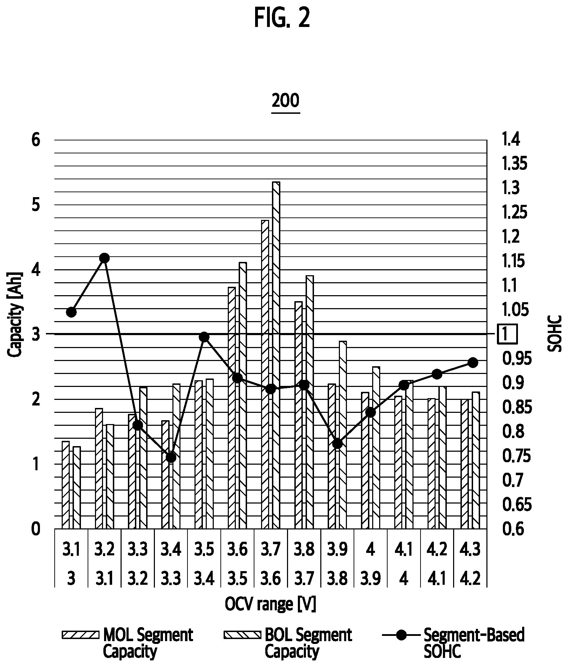

FIG. 2 illustrates a graph 200 representing the SOHC with respect to each OCV range of the manganese-rich cell and the capacity with respect to each OCV range at each of the BOL and the MOL of the manganese-rich cell.

In the graph 200 of FIG. 2, the MOL segment capacity and the BOL segment capacity represent capacities observed in a corresponding OCV range (e.g., the range of 3 V to 3.1 V and the range of 3.1 V to 3.2 V) at the MOL and the BOL of the manganese-rich cell. The segment-based SOHC represents the State of Health (SOH) with respect to the capacity in a corresponding OCV range of the manganese-rich cell, and is a value obtained by dividing the MOL segment capacity in a corresponding OCV range by the BOL segment capacity.

Referring to the graph 200, it may be seen that based on the point at which the OCV of the manganese-rich cell is 3.2 V, the MOL segment capacity is greater than the BOL segment capacity in the OCV ranges preceding the point (e.g., the range of 3 V to 3.1 V and the range of 3.1 V to 3.2 V), whereas the BOL segment capacity is greater than the MOL segment capacity in the OCV ranges subsequent to the point (e.g., the range of 3.2 V to 3.3 V and the range of 3.3 V to 3.4 V). Accordingly, it may be seen that the SOHC of the manganese-rich cell is higher than 1 in the OCV range equal to or less than 3.2 V, but lower than 1 in the OCV range equal to or greater than 3.2 V. For example, it may be understood that the capacity of the manganese-rich cell increases at the OCV equal to or less than 3.2 V where the SOHC is higher than 1, but decreases at the OCV equal to or greater than 3.2 V where the SOHC is lower than 1.

Based on the data above, it may be assumed that the SOC-OCV relationship of the manganese-rich cell may change based on a specific OCV value (e.g., 3.2 V).

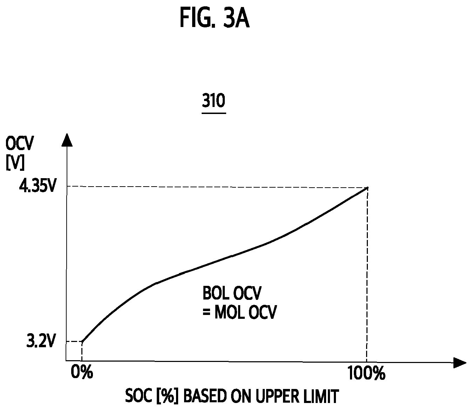

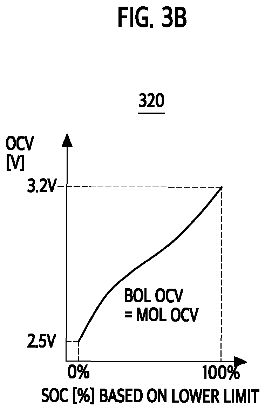

FIG. 3A illustrates a graph 310 representing the OCV with respect to the SOC in a first OCV range of the manganese-rich cell (e.g., 3.2 V to 4.35 V). FIG. 3B illustrates a graph 320 representing the OCV with respect to the SOC in a second OCV range of the manganese-rich cell (e.g., 2.5 V to 3.2 V). In the graph 310, the X axis represents the SOC of the manganese-rich cell scaled from 0 % to 100 % in the first OCV range. In the graph 320, the X axis represents the SOC of the manganese-rich cell scaled from 0 % to 100 % in the second OCV range.

Referring to the graph 310 of FIG. 3A and the graph 320 of FIG. 3B, it may be seen that based on the OCV value of 3.2 V, when the first OCV range is the range equal to or greater than 3.2 V, and the second OCV range is the range equal to or less than 3.2 V, the SOC-OCV relationship in each OCV range is consistent at the BOL and the MOL. For example, it may be understood that the SOC-OCV relationship of the manganese-rich cell changes based on the OCV of 3.2 V.

Accordingly, when estimating the SOC of the manganese-rich cell, the SOC in the first OCV range equal to or greater than the specific OCV (e.g., 3.2 V) may be estimated using the SOC-OCV relationship corresponding to the first OCV range, and the SOC in the second OCV range equal to or less than the specific OCV (e.g., 3.2 V) may be estimated using the SOC-OCV relationship corresponding to the second OCV range, so that the accurate SOC estimation may be achieved.

While descriptions have been made on an example where the OCV value at which the SOC-OCV relationship of the manganese-rich cell changes is about 3.2 V, the present disclosure is not limited thereto, and the OCV value at which the SOC-OCV relationship of the manganese-rich cell changes may vary according to, for example, the components of the manganese-rich cell.

FIG. 4 is a block diagram of an electronic apparatus 400 according to an embodiment of the present disclosure.

According to an embodiment, the electronic apparatus 400 may include a communication circuit 410, a sensor 420, a memory 430, and/or a processor 440. According to an embodiment, the electronic apparatus 400 illustrated in FIG. 4 may further include at least one component other than those illustrated in FIG. 4 (e.g., a display, an input device, or an output device).

According to an embodiment, the electronic apparatus 400 may be implemented as a battery management system disposed in a battery pack to manage and control the state of battery cells included in the battery pack. According to another embodiment, the electronic apparatus 400 may be implemented as at least one of a notebook, a desktop, a laptop, and a server computing device that receives data of battery cells from an external electronic apparatus to estimate the SOC.

According to an embodiment, the communication circuit 410 may establish a wired communication channel and/or a wireless communication channel between the electronic apparatus 400 and an external electronic apparatus and/or an external server that include battery cells, and transmit and receive data to/from the external electronic apparatus and/or the external server through the established communication channel. According to an embodiment, the communication circuit 410 may receive OCV data of battery cells from the external electronic apparatus and/or the external server.

Here, the communication, i.e., the data transmission and reception, may be performed in a wired or wireless manner. To this end, the communication circuit 310 may include a wired communication module that connects to the Internet or the like via a local area network (LAN), a mobile communication module that connects to a mobile communication network via a mobile communication base station to transmit and receive data, a short-range communication module that utilizes a wireless local area network (WLAN) type communication method such as Wi-Fi or a wireless personal area network (WPAN) type communication method such as Bluetooth or Zigbee, a satellite communication module that utilizes a global navigation satellite system (GNSS) such as a global positioning system (GPS), or a combination thereof.

According to an embodiment, the sensor 420 may measure values related to the state of the battery cell. According to an embodiment, the values related to the state may include at least one of a voltage value, a current value, and a temperature value of the battery cell.

According to an embodiment, either one of the communication circuit 410 and the sensor 420 in the electronic apparatus 400 may be omitted. For example, when the electronic apparatus 400 is implemented as a BMS, the communication circuit 410 may be omitted since the electronic apparatus 400 may acquire the OCV data by calculating the OCV based on the values related to the state of the battery cell measured by the sensor 420. As another example, when the electronic apparatus 400 is implemented as a computing device (e.g., a server) that receives the data of the battery cell from an external electronic apparatus, the sensor 420 may be omitted since the electronic apparatus 400 may acquire the OCV data of the battery cell through the communication circuit 410.

According to an embodiment, the memory 430 may include a volatile memory and/or a non-volatile memory.

According to an embodiment, the memory 430 may store data used by at least one component of the electronic apparatus 400 (e.g., the processor 440). For example, the data may include software (or its related instructions), input data, or output data. In an embodiment, the instructions may cause the electronic apparatus 400 to perform operations defined by the instructions when executed by the processor 440.

According to an embodiment, the memory 430 may store a plurality of estimation algorithms for estimating the SOC of the battery cell.

According to an embodiment, the processor 440 may be implemented as a computer or a device similar thereto according to hardware, software, or a combination thereof. For hardware, the processor 440 may be implemented in the form of an electronic circuit that processes an electrical signal to perform a control function, and for software, the processor 440 may be implemented in the form of a program that drives the hardware processor 440. In an embodiment, the processor 440 may include a central processing unit, an application processor, a graphics processing unit, a neural processing unit (NPU), an image signal processor, a sensor hub processor, or a communication processor.

Meanwhile, unless otherwise specified in the descriptions herein below, the operation of the electronic apparatus 400 may be interpreted as being performed under the control of the processor 440.

Hereinafter, the method of estimating the SOC of the battery cell by the electronic apparatus 400 will be described. Hereinafter, the battery cell may be the manganese-rich cell.

According to an embodiment, the electronic apparatus 400 may acquire the OCV data of the battery cell. For example, the OCV data may be time-series data representing the past and current OCV values of the battery cell. As described above, for example, when the electronic apparatus 400 is implemented as a BMS, the electronic apparatus 400 may acquire the OCV data by calculating the OCV based on the values related to the state of the battery cell measured by the sensor 420. Alternatively, when the electronic apparatus 400 is implemented as a computing device (e.g., a server) that receives the data of the battery cell from an external electronic apparatus, the electronic apparatus 400 may acquire the OCV data of the battery cell through the communication circuit 410.

According to an embodiment, the electronic apparatus 400 may identify an estimation algorithm from the plurality of estimation algorithms stored in the memory 430 based on the OCV data of the battery cell. According to an embodiment, based on the OCV data of the battery cell, the electronic apparatus 400 may identify an estimation algorithm to be used for estimating the SOC of the battery cell, from the plurality of estimation algorithms. For example, the electronic apparatus 400 may identify an estimation algorithm corresponding to an OCV range including an OCV value of the battery cell.

Here, the plurality of estimation algorithms may include a first estimation algorithm and a second estimation algorithm. The first estimation algorithm and the second estimation algorithm may correspond to the first OCV range and the second OCV range, respectively.

According to an embodiment, the electronic apparatus 400 may identify the OCV range including the OCV value of the battery cell based on the OCV data. Here, the entire OCV range of the battery cell may include the first OCV range and the second OCV range. For example, the first OCV range may be the range equal to or greater than a specified OCV value (e.g., 3.2 V), and the second OCV range may be the range less than the specified OCV value (e.g., 3.2 V). The electronic apparatus 400 may identify the OCV range including the OCV value of the battery cell from the first OCV range and the second OCV range.

According to an embodiment, the electronic apparatus 400 may identify an estimation algorithm corresponding to the OCV range including the OCV value of the battery cell, from the plurality of estimation algorithms. For example, when the OCV value of the battery cell is included in the first OCV range (e.g., the range equal to or greater than 3.2 V), the electronic apparatus 400 may identify the first estimation algorithm from the plurality of estimation algorithms. As another example, when the OCV value of the battery cell is included in the second OCV range (e.g., the range less than 3.2 V), the electronic apparatus 400 may identify the second estimation algorithm from the plurality of estimation algorithms.

According to an embodiment, the electronic apparatus 400 may estimate the SOC of the battery cell based on the estimation algorithm identified from the plurality of estimation algorithms.

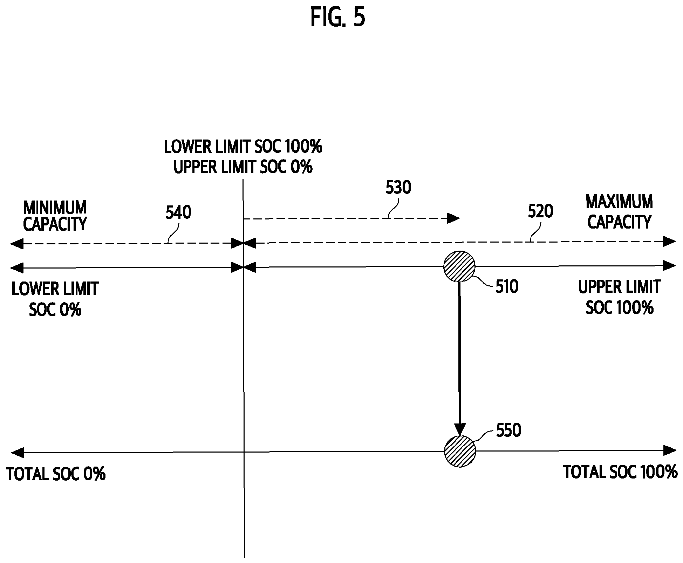

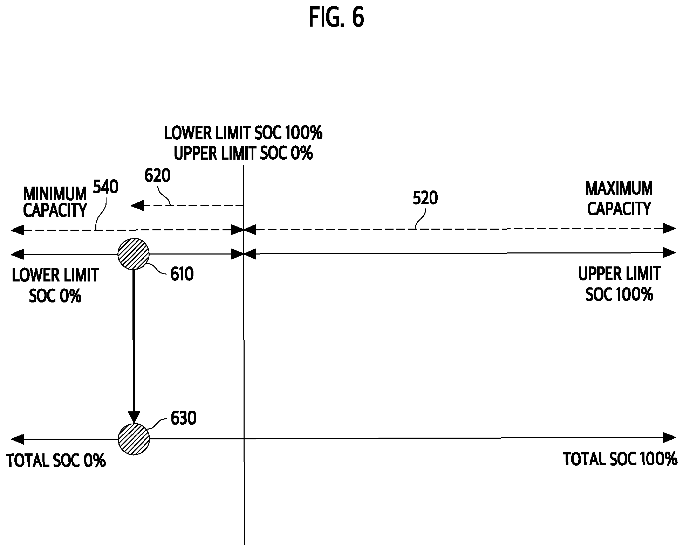

Hereinafter, with reference to FIGS. 5 and 6, descriptions will be made on the method of estimating the SOC of the battery cell based on the first estimation algorithm and the second estimation algorithm by the electronic apparatus 400. The descriptions of FIG. 5 below relate to the first estimation algorithm, and the descriptions of FIG. 6 below relate to the second estimation algorithm.

FIG. 5 is a view illustrating an example where the electronic apparatus 400 according to an embodiment of the present disclosure estimates the SOC of the battery cell based on the first estimation algorithm.

Referring to FIG. 5, the electronic apparatus 400 may estimate a first SOC 510 corresponding to the first OCV range, and estimate a SOC 550 corresponding to the entire OCV range including the first OCV range and the second OCV range based on the estimated first SOC 510, a first reference capacity 520, a charge capacity 530, and a second reference capacity 540.

According to an embodiment, the electronic apparatus 400 may estimate the SOC 550 corresponding to the entire OCV range of the battery cell based on first SOC-OCV relationship information corresponding to the first OCV range. Here, the first SOC-OCV relationship information may represent the SOC-OCV relationship in the first OCV range of a lithium nickel cobalt manganese oxide, which is part of the lithium-excess manganese-rich oxide. For example, the first SOC-OCV relationship information may be a lookup table representing the SOC associated with an OCV value in the first OCV range.

According to an embodiment, the electronic apparatus 400 may estimate the first SOC 510 corresponding to the first OCV range based on the first SOC-OCV relationship information acquired from the lookup table. Here, the first SOC 510 may be in the range of 0 % to 100 % scaled within the first OCV range. For example, the first SOC 510 may be understood to represent the SOC in the first OCV range, rather than the entire SOC of the battery cell. For example, the electronic apparatus 400 may estimate the first SOC 510 by performing an Extended Kalman Filter operation based on the first SOC-OCV relationship information acquired from the lookup table and the OCV value of the battery cell corresponding to the specific OCV range.

According to an embodiment, the electronic apparatus 400 may multiply the first SOC 510 and the first reference capacity 520 to obtain the charge capacity 530 based on the specified OCV value (e.g., 3.2 V). Here, the first reference capacity 520 may correspond to the first OCV range. For example, the first reference capacity 520 may be the capacity (e.g., 80 Ah) corresponding to the total capacity of the battery cell (e.g., 100 Ah) minus the capacity at the specified OCV value (e.g., 3.2 V) (e.g., 20 Ah). The charge capacity 530 may be the capacity required for a charging from the specified OCV value to the current OCV value of the battery cell.

According to an embodiment, the electronic apparatus 400 may calculate the charge capacity 530 based on Equation 1 below.

### [Equation 1]

According to an embodiment, the electronic apparatus 400 may estimate the SOC 550 of the battery cell by dividing the sum of the second reference capacity 540 and the charge capacity 530 by the sum of the first reference capacity 520 and the second reference capacity 540. Here, the second reference capacity 540 may correspond to the second OCV range. For example, the second reference capacity 540 may be the capacity (e.g., 20 Ah) at the specified OCV value (e.g., 3.2 V) of the battery cell.

According to an embodiment, the electronic apparatus 400 may calculate the SOC 550 corresponding to the entire OCV range of the battery cell based on Equation 2 below. [Equation 2] $SOC \left[%\right] = \frac{Charge Capacity \left[Ah\right] + Second Reference Capacity \left[Ah\right]}{First Reference Capacity \left[Ah\right] + Second Reference Capacity \left[Ah\right]} \times 100$

FIG. 6 is a view illustrating an example where the electronic apparatus 400 according to an embodiment of the present disclosure estimates the SOC of the battery cell based on the second estimation algorithm.

Referring to FIG. 6, the electronic apparatus 400 may estimate a second SOC 610 corresponding to the second OCV range, and estimate an SOC 630 corresponding to the entire OCV range including the first OCV range and the second OCV range based on the estimated second SOC 610, the first reference capacity 520, the second reference capacity 540, and a discharge capacity 620.

According to an embodiment, the electronic apparatus 400 may estimate the SOC 630 corresponding to the entire OCV range of the battery cell based on second SOC-OCV relationship information corresponding to the second OCV range. Here, the second SOC-OCV relationship information may represent the SOC-OCV relationship in the second OCV range of a lithium manganese oxide, which is part of the lithium-excess manganese-rich oxide. For example, the second SOC-OCV relationship information may be a lookup table representing SOC associated with an OCV value in the second OCV range.

According to an embodiment, the electronic apparatus 400 may estimate the second SOC 610 corresponding to the second OCV range based on the second SOC-OCV relationship information acquired from the lookup table. Here, the second SOC 610 may be in the range of 0 % to 100 % scaled within the second OCV range. For example, the second SOC 610 may be understood to represent the SOC in the second OCV range, rather than the entire SOC of the battery cell. For example, the electronic apparatus 400 may estimate the second SOC 610 by performing the Extended Kalman Filter operation based on the second SOC-OCV relationship information acquired from the lookup table and the OCV value of the battery cell corresponding to the specific OCV range.

According to an embodiment, the electronic apparatus 400 may calculate a first Depth of Discharge (DoD) corresponding to the second OCV range based on the second SOC 610. For example, the electronic apparatus 400 may calculate the first DoD based on a specified operation (e.g., 100-second SOC).

According to an embodiment, the electronic apparatus 400 may multiply the first DoD and the second reference capacity 540 to obtain the discharge capacity 620 based on the specified OCV value (e.g., 3.2 V). Here, the discharge capacity 620 may be the capacity discharged from the specified OCV value (e.g., 3.2 V) to the current OCV value of the battery cell.

According to an embodiment, the electronic apparatus 400 may calculate the discharge capacity 620 based on Equation 3 below. [Equation 3] $Discharge Capacity \left[Ah\right] = \frac{First DoD \left[%\right]}{100} \times Second Reference Capacity \left[Ah\right]$

According to an embodiment, the electronic apparatus 400 may calculate a second DoD of the battery cell by dividing the sum of the first reference capacity 520 and the discharge capacity 620 by the sum of the first reference capacity 520 and the second reference capacity 540. Here, the second DoD may correspond to the entire OCV range of the battery cell.

According to an embodiment, the electronic apparatus 400 may calculate the second DoD of the battery cell based on Equation 4 below. [Equation 4] $Second DoD \left[%\right] = \frac{First Reference Capacity \left[Ah\right] + Discharge Capacity \left[Ah\right]}{First Reference Capacity \left[Ah\right] + Second Reference Capacity \left[Ah\right]} \times 100$

According to an embodiment, the electronic apparatus 400 may calculate the SOC 630 of the battery cell based on the second DoD. For example, the electronic apparatus 400 may calculate the SOC 630 corresponding to the entire OCV range including the first OCV range and the second OCV range based on a specified operation (e.g., 100-second DoD).

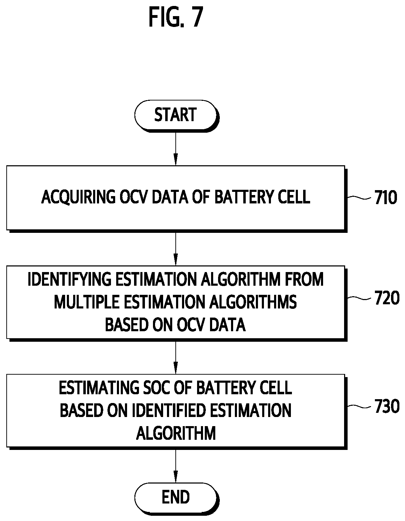

FIG. 7 is a flowchart illustrating the operation of the electronic apparatus according to an embodiment of the present disclosure. Since the operation method of FIG. 7 may be performed by the electronic apparatus 400 of FIG. 4, its descriptions may be omitted when overlapping with the foregoing descriptions, or may be made using the components of FIG. 4.

The embodiment illustrated in FIG. 7 is merely an example, and the sequence of operations according to various embodiments of the present disclosure may differ from that illustrated in FIG. 7. Part of the operations illustrated in FIG. 7 may be omitted, the sequence of operations may be changed, or the operations may be merged.

Referring to FIG. 7, at operation 710, the electronic apparatus 400 may acquire the OCV data of the battery cell. For example, the OCV data may be time-series data representing the past and current OCV values of the battery cell. As described above, for example, when the electronic apparatus 400 is implemented as a BMS, the electronic apparatus 400 may acquire the OCV data by calculating the OCV based on the values related to the state of the battery cell measured by the sensor 420. Alternatively, when the electronic apparatus 400 is implemented as a computing device (e.g., a server) that receives the data of the battery cell from an external electronic apparatus, the electronic apparatus 400 may acquire the OCV data of the battery cell through the communication circuit 410.

At operation 720, the electronic apparatus 400 may identify an estimation algorithm corresponding to the OCV range including the OCV value of the battery cell from the plurality of estimation algorithms stored in the memory 430, based on the OCV data of the battery cell acquired at operation 710.

At operation 730, the electronic apparatus 400 may estimate the SOC corresponding to the entire OCV range of the battery cell based on the estimation algorithm identified at operation 720.

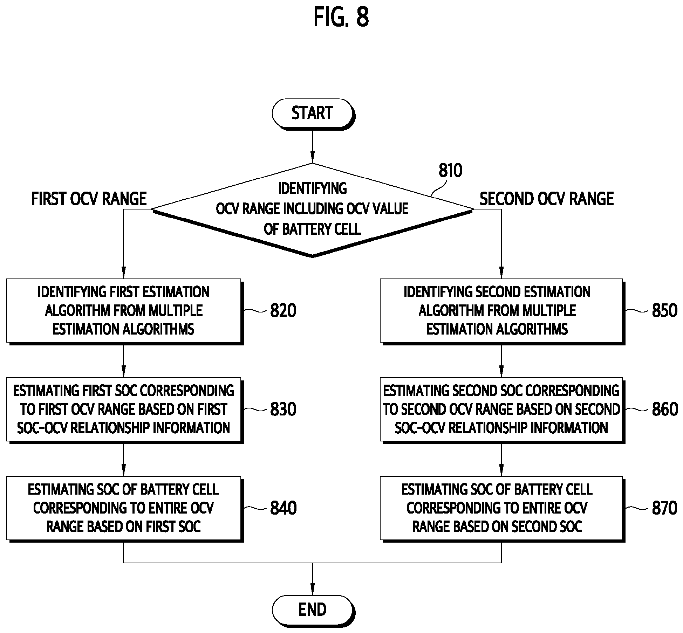

With reference to FIG. 8, more detailed descriptions will be made below on operation 720 in which the electronic apparatus 400 identifies an estimation algorithm from the plurality of estimation algorithms and operation 730 in which the electronic apparatus 400 estimates the SOC corresponding to the entire OCV range of the battery cell based on the identified estimation algorithm.

FIG. 8 is a flowchart illustrating the operation of the electronic apparatus according to an embodiment of the present disclosure. Since the operation method of FIG. 8 may be performed by the electronic apparatus 400 of FIG. 4, its descriptions may be omitted when overlapping with the foregoing descriptions, or may be made using the components of FIG. 4.

The embodiment illustrated in FIG. 8 is merely an example, and the sequence of operations according to various embodiments of the present disclosure may differ from that illustrated in FIG. 8. Part of the operations illustrated in FIG. 8 may be omitted, the sequence of the operations may be changed, or the operations may be merged.

Referring to FIG. 8, at operation 810, the electronic apparatus 400 may identify the OCV range including the OCV value of the battery cell based on the OCV data acquired at operation 710 of FIG. 7. Here, the entire OCV range of the battery cell may include the first OCV range and the second OCV range. For example, the first OCV range may be the range equal to or greater than the specified OCV value (e.g., 3.2 V), and the second OCV range may be the range less than the specified OCV value. The electronic apparatus 400 may identify the OCV range including the OCV value of the battery cell from the first OCV range and the second OCV range.

When it is identified at operation 810 that the OCV value of the battery cell is included in the first OCV range, the operation proceeds to operation 820 (operation 810-first OCV range), such that the electronic apparatus 400 may identify the first estimation algorithm from the plurality of estimation algorithms stored in the memory 430.

At operation 830, the electronic apparatus 400 may estimate the first SOC corresponding to the first OCV range based on the first SOC-OCV relationship information corresponding to the first OCV range. Here, the first SOC may be in the range of 0 % to 100 %. For example, it may be understood that the first SOC represents the SOC scaled in the first OCV range, rather than the entire SOC of the battery cell. For example, the electronic apparatus 400 may estimate the first SOC scaled in the first OCV range by performing the Extended Kalman Filter operation based on the first SOC-OCV relationship information and the OCV value of the battery cell.

At operation 840, the electronic apparatus 400 may estimate the SOC of the battery cell corresponding to the entire OCV range based on the first SOC estimated at operation 830.

According to an embodiment, the electronic apparatus 400 may multiply the first SOC and the first reference capacity to obtain the charge capacity based on the specified OCV value (e.g., 3.2 V). Here, the first reference capacity may correspond to the first OCV range. For example, the first reference capacity may be the capacity (e.g., 80 Ah) corresponding to the total capacity of the battery cell (e.g., 100 Ah) minus the capacity at the specified OCV value (e.g., 3.2 V) (e.g., 20 Ah). The charge capacity may be the capacity required for a charging from the specified OCV value to the current OCV value of the battery cell.

According to an embodiment, the electronic apparatus 400 may estimate the SOC of the battery cell by dividing the sum of the second reference capacity and the charge capacity by the sum of the first reference capacity and the second reference capacity. Here, the second reference capacity may correspond to the second OCV range. For example, the second reference capacity may be the capacity at the specified OCV value of the battery cell (e.g., 20 Ah).

When it is identified at operation 810 that the OCV value of the battery cell is included in the second OCV range, the operation proceeds to operation 850 (operation 810-second OCV range), such that the electronic apparatus 400 may identify the second estimation algorithm from the plurality of estimation algorithms stored in the memory 430.

At operation 860, the electronic apparatus 400 may estimate the second SOC corresponding to the second OCV range based on the second SOC-OCV relationship information corresponding to the second OCV range. Here, the second SOC may be in the range of 0 % to 100 %. For example, it may be understood that the second SOC represents the SOC scaled in the second OCV range, rather than the entire SOC of the battery cell. For example, the electronic apparatus 400 may estimate the second SOC scaled in the second OCV range by performing the Extended Kalman Filter operation based on the second SOC-OCV relationship information and the OCV value of the battery cell.

At operation 870, the electronic apparatus 400 may estimate the SOC of the battery cell corresponding to the entire OCV range based on the second SOC estimated at operation 860.

According to an embodiment, the electronic apparatus 400 may calculate the first DoD corresponding to the second OCV range based on the second SOC.

According to an embodiment, the electronic apparatus 400 may multiply the first DoD and the second reference capacity to obtain the discharge capacity based on the specified OCV value (e.g., 3.2 V). Here, the discharge capacity may be the capacity discharged from the specified OCV value to the current OCV value of the battery cell.

According to an embodiment, the electronic apparatus 400 may calculate the second DoD of the battery cell by dividing the sum of the first reference capacity and the discharge capacity by the sum of the first reference capacity and the second reference capacity. Here, the second DoD may correspond to the entire OCV range of the battery cell.

According to an embodiment, the electronic apparatus 400 may calculate the SOC of the battery cell based on the second DoD. For example, the electronic apparatus 400 may calculate the SOC based on the specified operation (e.g., 100-second DoD).

The battery management system according to the foregoing embodiments may include, for example, a processor, a memory storing and executing program data, a permanent storage such as a disk drive, a communication port for communicating with an external device, and a user interface device such as a touch panel, keys, or icons. The methods implemented by software modules or algorithms may be stored on a computer-readable record medium as computer-readable codes or program instructions executable on the processor. Here, the computer-readable record medium includes a magnetic storage medium (e.g., a read-only memory (ROM), a random-access memory (RAM), a floppy disk, and a hard disk) and an optical readable medium (e.g., a CD-ROM and a DVD (Digital Versatile Disc)). The computer-readable record medium may be distributed in computer systems connected through a network, such that computer-readable codes may be stored and executed in a distributed manner. The medium is readable by a computer, stored in a memory, and executable by a processor.

The various embodiments of the present disclosure may be represented by functional block components and various processing steps. The functional blocks may be implemented by various numbers of hardware and/or software components that execute specific functions. For example, an embodiment may adopt direct circuit components such as a memory, processing, logic, and look-up tables that may execute various functions under the control of one or more microprocessors or other control devices. Similar to the case where components may be executed by software programing or software components, the embodiments of the present disclosure may be implemented in a programming or scripting language such as C, C++, Java, or assembler, including various algorithms implemented by data structures, processes, routines, or combinations of other programming components. The functional aspects may be implemented by algorithms executed on one or more processors. Further, the embodiments of the present disclosure may adopt conventional techniques for electronic environment setup, signal processing, and/or data processing. Terms such as "mechanism," "components," "means," and "configuration" may be used in a broad sense, and are not limited to mechanical and physical components. These terms may include the meaning of a series of routines executed by software in conjunction with a processor or the like.

The foregoing embodiments are merely examples, and other embodiments may be implemented within the scope of the following claims.

## Claims

1. An electronic apparatus comprising:
a memory storing a plurality of estimation algorithms for estimating a state of charge (SOC) of a battery cell; and
a processor operatively coupled to the memory,
wherein the processor
acquires open circuit voltage (OCV) data of the battery cell,
based on the acquired OCV data of the battery cell, identifies any one estimation algorithm from the plurality of estimation algorithms stored in the memory, and
based on the identified estimation algorithm, estimates the SOC of the battery cell.

2. The electronic apparatus according to claim 1, wherein the plurality of
estimation algorithms include a first estimation algorithm and a second estimation algorithm,
based on the acquired OCV data, the processor identifies an OCV range including an OCV value of the battery cell,
when the OCV value of the battery cell is included in a first OCV range, the processor identifies the first estimation algorithm from the plurality of estimation algorithms, and
when the OCV value of the battery cell is included in a second OCV range, the processor identifies the second estimation algorithm from the plurality of estimation algorithms.

3. The electronic apparatus according to claim 2, wherein when the first
estimation algorithm is identified from the plurality of estimation algorithms, the processor estimates the SOC of the battery cell based on first SOC-OCV relationship information corresponding to the first OCV range, and
when the second estimation algorithm is identified from the plurality of estimation algorithms, the processor estimates the SOC of the battery cell based on second SOC-OCV relationship information corresponding to the second OCV range.

4. The electronic apparatus according to claim 3, wherein when the first estimation algorithm is identified from the plurality of estimation algorithms, the processor estimates a first SOC corresponding to the first OCV range based on the first SOC-OCV relationship information, and based on the first SOC, estimates the SOC of the battery cell corresponding to an entire OCV range including the first OCV range and the second OCV range, and
when the second estimation algorithm is identified from the plurality of estimation algorithms, the processor estimates a second SOC corresponding to the second OCV range based on the second SOC-OCV relationship information, and
based on the second SOC, estimates the SOC of the battery cell corresponding to an entire OCV range including the first OCV range and the second OCV range.

5. The electronic apparatus according to claim 4, wherein the first OCV range is a range equal to or greater than a specified OCV value, and
the second OCV range is a range less than the specified OCV value.

6. The electronic apparatus according to claim 5, wherein when the first estimation algorithm is identified from the plurality of estimation algorithms, the processor estimates the first SOC by performing an Extended Kalman Filter operation based on the first SOC-OCV relationship information and the OCV value of the battery cell,
multiplies the first SOC by a first reference capacity corresponding to the first OCV range to obtain a charge capacity based on the specified OCV value, and
divides a sum of a second reference capacity corresponding to the second OCV range and the charge capacity by a sum of the first reference capacity and the second reference capacity to estimate the SOC of the battery cell.

7. The electronic apparatus according to claim 6, wherein the battery cell includes a lithium-excess manganese-rich oxide as a positive electrode active material, and
the first SOC-OCV relationship information represents a relationship between an SOC and an OCV in the first OCV range of a lithium nickel cobalt manganese oxide that is part of the lithium-excess manganese-rich oxide.

8. The electronic apparatus according to claim 5, wherein when the second estimation algorithm is identified from the plurality of estimation algorithms, the processor estimates the second SOC by performing an Extended Kalman Filter operation based on the second SOC-OCV relationship information and the OCV value of the battery cell,
based on the second SOC, calculates a first depth of discharge (DoD) corresponding to the second OCV range,
multiplies the first DoD by a second reference capacity corresponding to the second OCV range to obtain a discharge capacity based on the specified OCV value,
divides a sum of the first reference capacity corresponding to the first OCV range and the discharge capacity by a sum of the first reference capacity and the second reference capacity to obtain a second DoD of the battery cell corresponding to the entire OCV range of the battery cell, and based on the second DoD, estimates the SOC of the battery cell.

9. The electronic apparatus according to claim 8, wherein the battery cell includes a lithium-excess manganese-rich oxide as a positive electrode active material, and
the second SOC-OCV relationship information represents a relationship between an SOC and an OCV in the second OCV range of a lithium manganese oxide that is part of the lithium-excess manganese-rich oxide.

10. An SOC estimation method of a battery cell performed by an electronic apparatus, the method comprising:
acquiring OCV data of the battery cell;
based on the acquired OCV data, identifying any one estimation algorithm from a plurality of estimation algorithms; and
based on the identified estimation algorithm, estimating the SOC of the battery cell.

11. The SOC estimation method according to claim 10, wherein the plurality of estimation algorithms include a first estimation algorithm and a second estimation algorithm, and
the identifying any one estimation algorithm from the plurality of estimation algorithms includes
based on the acquired OCV data, identifying an OCV range including an OCV value of the battery cell,
when the OCV value of the battery cell is included in the first OCV range, identifying the first estimation algorithm from the plurality of estimation algorithms, and
when the OCV value of the battery cell is included in the second OCV range, identifying the second estimation algorithm from the plurality of estimation algorithms.

12. The SOC estimation method according to claim 11, wherein the estimating the SOC of the battery cell includes
when the first estimation algorithm is identified from the plurality of estimation algorithms,
estimating a first SOC corresponding to the first OCV range based on the first SOC-OCV relationship information, and
based on the first SOC, estimating the SOC of the battery cell corresponding to an entire OCV range including the first OCV range and the second OCV range, and
when the second estimation algorithm is identified from the plurality of estimation algorithms,
estimating a second SOC corresponding to the second OCV range based on the second SOC-OCV relationship information, and
based on the second SOC, estimating the SOC of the battery cell corresponding to an entire OCV range including the first OCV range and the second OCV range.

13. The SOC estimation method according to claim 12, wherein the first OCV range is a range equal to or greater than a specified OCV value, and
the second OCV range is a range less than the specified OCV value.

14. The SOC estimation method according to claim 13, wherein the estimating the SOC of the battery cell includes
when the first estimation algorithm is identified from the plurality of estimation algorithms, estimating the first SOC by performing an Extended Kalman Filter operation based on the first SOC-OCV relationship information and the OCV value of the battery cell,
multiplying the first SOC by a first reference capacity corresponding to the first OCV range to obtain a charge capacity based on the specified OCV value, and
dividing a sum of a second reference capacity corresponding to the second OCV range and the charge capacity by a sum of the first reference capacity and the second reference capacity to estimate the SOC of the battery cell.

15. The SOC estimation method according to claim 13, wherein the estimating the SOC of the battery cell includes
when the second estimation algorithm is identified from the plurality of estimation algorithms, estimating the second SOC by performing an Extended Kalman Filter operation based on the second SOC-OCV relationship information and the OCV value of the battery cell,
based on the second SOC, calculating a first depth of discharge (DoD) corresponding to the second OCV range,
multiplying the first DoD by a second reference capacity corresponding to the second OCV range to obtain a discharge capacity based on the specified OCV value,
dividing a sum of the first reference capacity corresponding to the first OCV range and the discharge capacity by a sum of the first reference capacity and the second reference capacity to obtain a second DoD of the battery cell corresponding to the entire OCV range of the battery cell, and based on the second DoD, estimating the SOC of the battery cell.

16. The electronic apparatus according to claim 1, wherein the processor directly acquires the OCV data measured by a sensor, or acquires the OCV data from an external apparatus through a communication.

17. The electronic apparatus according to claim 5, wherein the specified OCV value is about 3.2 V.

18. The SOC estimation method according to claim 10, wherein the acquiring the OCV data includes directly acquiring the OCV data measured by a sensor, or acquiring the OCV data from an external apparatus through a communication.

19. The SOC estimation method according to claim 13, wherein the specified OCV value is about 3.2 V.
